# EUROPÄISCHE PATENTSCHRIFT

(11) **EP 2 043 211 B1**
(45) Veröffentlichungstag und Bekanntmachung des Hinweises auf die Patenterteilung: **26.10.2011**
(21) Anmeldenummer: 08011020.8
(22) Anmeldetag: 18.06.2008
(51) Int. Cl.: H01S 5/40

(54) **Laservorrichtung**
Laser device
Dispositif laser

(30) Priorität: 26.09.2007 DE 102007045845
(43) Veröffentlichungstag der Anmeldung: 01.04.2009
(73) Patentinhaber: Arctos Showlasertechnik GmbH, 83416 Saaldorf-Surheim (DE)
(72) Erfinder: Hafner, Thomas, 83416 Saaldorf-Surheim (DE)
(74) Vertreter: Hofmann, Matthias

(56) Entgegenhaltungen:
- WO-A1-92/02844
- DE-U1-202005 009 294
- US-A- 4 978 197
- US-A- 5 715 270

## Beschreibung

Die Erfindung betrifft eine Laservorrichtung mit einer Mehrzahl von Singleemitter-Laserdioden, deren Einzel-Ausgabestrahlen zu einem Gesamt-Ausgabestrahl überlagert werden, nach dem Oberbegriff des Anspruchs 1.

Eine derartige Laservorrichtung ist bekannt aus der DE 20 2005 009 294 U1. Zum Einsatz einer derartigen Laservorrichtung für Showlaser-Projektionszwecke ist es von zentraler Bedeutung, dass ein möglichst gut gebündelter Gesamt-Ausgabestrahl mit möglichst hoher mittlerer Leistung vorliegt.

Es ist daher eine Aufgabe der vorliegenden Erfindung, eine Laservorrichtung der eingangs genannten Art derart weiterzubilden, dass bei gegebener mittlerer Leistung im Gesamt-Ausgabelaserstrahl eine verbesserte Bündelung dieses Ausgabestrahls erreicht werden kann.

Diese Aufgabe ist erfindungsgemäß gelöst durch eine Laservorrichtung mit den im Kennzeichnungsteil des Anspruchs 1 angegebenen Merkmalen.

Erfindungsgemäß wurde erkannt, dass es überraschenderweise durchaus möglich ist, einen Teil der verwendeten Einzel-Ausgabestrahlen an Zusammenführ-Umlenkelementen abzuschneiden, so dass der abgeschnittene Teil nicht als Nutzlicht zur Verfügung steht. Der scheinbare Nachteil, den dieses Abschneiden aufgrund einer Verringerung der nutzbaren Gesamtintensität zur Folge hat, wird durch den Vorteil der Möglichkeit einer engeren Zusammenführung der nebeneinander verlaufenden Einzel-Ausgabestrahlen mehr als aufgewogen. Insgesamt resultiert ein gut gebündelter Gesamt-Ausgabestrahl, der sich gut zu Projektionszwecken einsetzen lässt.

Ebenfalls überraschend ist, dass Beugungseffekte aufgrund der abgeschnittenen Einzelstrahl-Anteile keinen negativen Effekt auf eine Projektionsqualität des Gesamt-Ausgabestrahls haben.

Abgeschnittene Intensitäten nach Anspruch 2 stellen einen guten Kompromiss zwischen einem möglichst geringen abzuschneidenden Intensitäts-Anteil einerseits und einem möglichst engen Zusammenführen benachbart nebeneinander verlaufender Einzel-Ausgabestrahlen dar. Mehr als 20% der Gesamtintensität eines Einzel-Ausgabestrahls sollten allerdings nicht abgeschnitten werden. Der abgeschnittene Teil kann mindestens 10% der Gesamtintensität des Einzel-Ausgabestrahls vor dem Zusammenführ-Umlenkspiegel beinhalten.

Eine Laservorrichtung nach Anspruch 3 gewährleistet einen Gesamt-Ausgabestrahl, bei dem alle Einzel-Ausgabestrahlen vorteilhaft eng zueinander benachbart verlaufen.

Ein Gesamt-Kollimator nach Anspruch 4 führt zu einer weiteren Verengung des Bündeldurchmessers des Gesamt-Ausgabestrahls dort, wo der enge Bündeldurchmesser bei der Projektion benötigt wird. Ein typischer 1/e-Bündelquerschnitt ist ein über alle Querschnittsrichtungen des Bündels gemittelter 1/e-Bündelquerschnitt. Ein in z-Richtung propagierendes elliptisches Bündel, das beispielsweise in x-Richtung einen 1/e-Bündelquerschnitt von 3 mm und in y-Richtung einen 1/e-Bündelquerschnitt von 7 mm hat, weist einen typischen 1/e-Bündelquerschnitt von etwa 5 mm auf. 1/e-Bündelquerschnitte nach Anspruch 4 haben sich zur Erzeugung einer guten Projektionsqualität als bevorzugt herausgestellt. Der 1/e-Bündelquerschnitt kann durch den Gesamt-Kollimator auf höchstens 8 mm, mehr bevorzugt auf mindestens 6 mm und noch mehr bevorzugt auf höchstens 5 mm verringert werden.

Nach Anspruch 5 justierte Umlenkspiegel führen eine nochmalige Verengung des Gesamt-Ausgabestrahls herbei. Hierbei wird der Aufbau des Gesamt-Ausgabestrahls aus mehreren Einzel-Ausgabestrahlen genutzt, wobei die Einzel-Ausgabestrahlen unabhängig voneinander in ihrer Richtung justiert werden können. Die energetischen Hauptstrahlen der Einzel-Ausgabestrahlen innerhalb des Gruppen-Strahl-Arrays rücken längs des Strahlengangs des Gruppen-Strahl-Arrays dann zusammen, wenn sich der Abstand benachbarter energetischer Hauptstrahlen der Einzel-Ausgabestrahlen längs des Strahlengangs verringert.

Die Weiterbildung nach Anspruch 6 nutzt die Möglichkeiten einer unabhängigen Justage der Einzel-Ausgabestrahlen in besonders vorteilhafter Weise zur Erzeugung eines geringen Querschnitts des Gesamt-Ausgabestrahls. Die energetischen Hauptstrahlen der Einzel-Ausgabestrahlen können nach einem Lichtweg des Gruppen-Strahl-Arrays von mehr als 5 m, von mehr als 10 m oder von mehr als 20 m zusammenfallen.

Spezifikationen der Emissionen der Singleemitter-Laserdioden nach den Ansprüchen 7 bis 10 haben sich für den Einsatz derartiger Laserdioden in der erfindungsgemäßen Laservorrichtung als besonders gut geeignet herausgestellt. Das Aspektverhältnis der Emissionsfläche der Singleemitter-Laserdioden kann im Bereich zwischen 1:1,3 und 1:1,7 liegen. Eine lange Hauptachse der Emissionsfläche kann nicht länger sein als 1,7 µm. Ein Aspektverhältnis einer Divergenz des Einzel-Ausgabestrahls der Singleemitter-Laserdioden kann im Bereich von 1:1,3 und 1:1,7 liegen. Eine Obergrenze der maximalen Strahldivergenz der Singleemitter-Laserdioden kann bei 20 mrad liegen, so dass die maximale Strahldivergenz nicht größer ist als 20 mrad.

Ein Ausführungsbeispiel der Erfindung wird nachfolgend anhand der Zeichnung näher erläutert. In dieser zeigen:
- Fig. 1: eine schematische Gesamtübersicht einer Laservorrichtung mit einer Mehrzahl von Singleemitter-Laserdioden, deren Einzel-Ausgabestrahlen zu einem Gesamt-Ausgabestrahl ü- berlagert werden, wobei diese Laservorrichtung Teil einer schematisch dargestellten Gesamtvorrichtung zur scannenden Showlaser-Projektion ist;
- Fig. 2: eine schematische Ansicht auf die Laservorrichtung gemäß der Schnittlinie II-II in Fig. 1;
- Fig. 3: eine Ausschnittsvergrößerung gemäß dem Ausschnitt III in Fig. 1;
- Fig. 4: eine Ausschnittsvergrößerung von Fig. 2;
- Fig. 5: ein Intensitätsprofil ausgewählter Einzel-Ausgabestrahlen gemäß den Schnittlinien V-V in den Fig. 3 und 4;
- Fig. 6: schematisch die Emissionsfläche einer der Singleemitter- Laserdioden;
- Fig. 7: einen Schnitt durch den Gesamt-Ausgabestrahl gemäß Linie VII-VII in Fig. 1, wobei lediglich die Einzel-Ausgabestrahlen der Singleemitter-Laserdioden dargestellt sind; und
- Fig. 8 und 9: Schnitte durch den Gesamt-Ausgabestrahl gemäß Linie VIII- VIII in Fig. 1 in einer zu Fig. 7 ähnlichen Darstellung in ver- schiedenen Justagezuständen der Laservorrichtung.

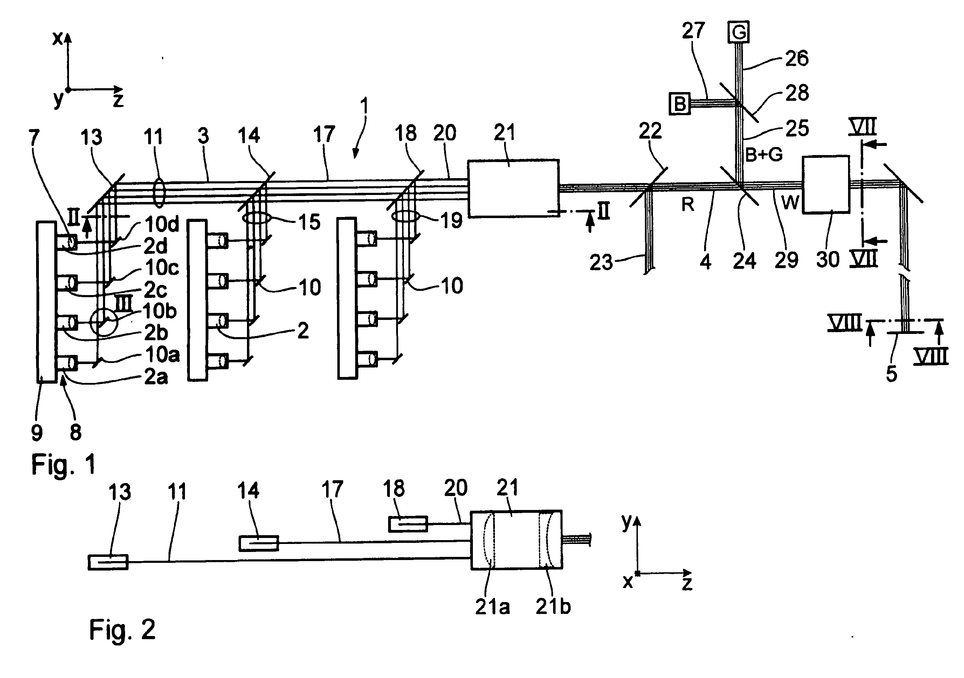

Zur Veranschaulichung von Lagebeziehungen ist der Fig. 1 und weiteren Figuren der Zeichnung ein kartesisches x-y-z-Koordinatensystem zugeordnet. Die x-Achse verläuft in der Fig. 1 nach oben. Die y-Achse verläuft senkrecht zur Zeichenebene der Fig. 1 auf den Betrachter zu und die z-Achse verläuft nach rechts.

Eine Laservorrichtung 1 hat eine Mehrzahl von Singleemitter-Laserdioden 2, deren Einzel-Ausgabestrahlen 3 zu einem Gesamt-Ausgabestrahl 4 überlagert werden. Der erzeugte Gesamt-Ausgabestrahl 4 wird dann mit dem Licht weiterer Laser zusammengekoppelt, so dass ein Weißlicht-Strahl erzeugt wird, der dann zu Showlaser-Zwecken beispielsweise über eine Projektionsfläche 5 gescannt wird. Die Laservorrichtung 1 erzeugt dabei den Rotlicht-Anteil des zu scannenden Weißlichtstrahls.

Als Singleemitter-Laserdioden 2 werden beispielsweise Laserdioden mit einer Ausgabewellenlänge von 660 nm und einer mittleren Ausgabeleistung von 130 mW im cw-Betrieb (continuous wave) eingesetzt.

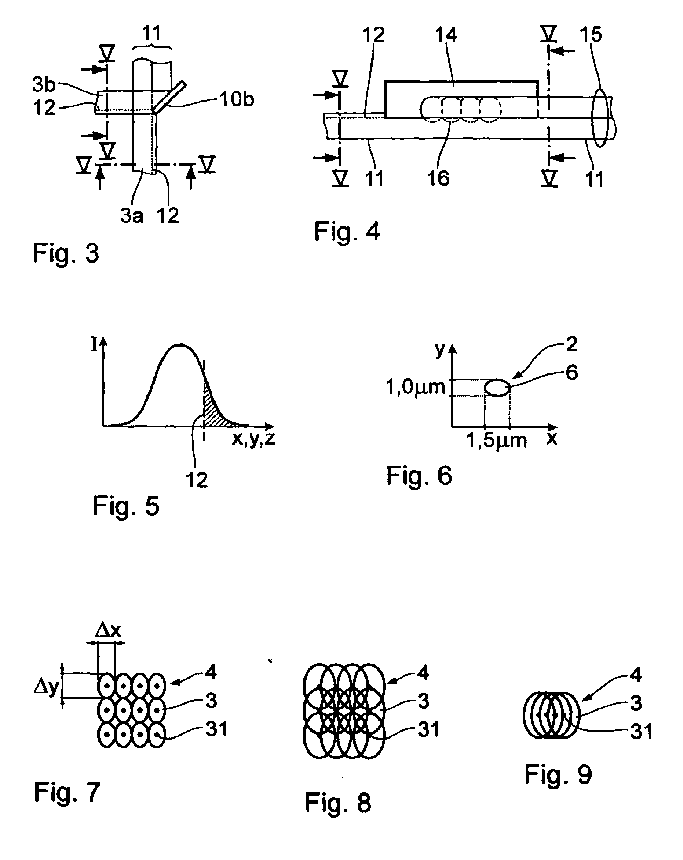

Fig. 6 zeigt eine typische Emissionsfläche 6 einer der Singleemitter-Laserdioden 2. Die Emissionsfläche 6 ist in etwa elliptisch und hat in x-Richtung eine Ausdehnung von typisch 1,5 µm und in y-Richtung eine Ausdehnung von typisch 1,0 µm. Diese Ausdehnung in x- und y-Richtung jeweils zugeordnet ist eine typische Strahldivergenz des Einzel-Ausgabestrahls 3 dieser Singleemitter-Laserdiode 2. Je kleiner die Querausdehnung der Emissionsfläche 6 ist, desto größer ist bei der Singleemitter-Laserdiode 2 die Strahldivergenz in der diese Querausdehnung enthaltenden Hauptebene. Jede der Singleemitter-Laserdioden 2 hat unmittelbar nach der Emissionsfläche 6 einen ersten Kollimator 7, der die Divergenz des Einzel-Ausgabestrahls 3 in der x-Richtung auf etwa 7 mrad und in der y-Richtung auf etwa 16 mrad reduziert. Im weiteren Verlauf durch die Laservorrichtung 1 ist aufgrund dieser sehr geringen Divergenzen in x- und y-Richtung praktisch keine Aufweitung der Einzel-Ausgabestrahlen 3 vorhanden.

Die lange Hauptachse der Emissionsfläche 6, also die x-Achse, ist bei den verwendeten Singleemitter-Laserdioden 2 nicht länger als 1,7 µm.

Das Aspektverhältnis der Divergenzen in x- und y-Richtung beträgt bei den verwendeten Singleemitter-Laserdioden 2 1:1,3 bis 1:2,5. Bevorzugt beträgt dieses Divergenzverhältnis x/y 1:1,5.

Auch anderen Singleemitter-Laserdioden können eingesetzt werden, beispielsweise eine Singleemitter-Laserdiode mit einer Ausgabewellenlänge von 642 nm und einer cw-Ausgabeleistung von 90 mW, einer Divergenz in x-Richtung von 10 mrad und in y-Richtung von 21 mrad. Typische Emissionsflächen der verwendeten Singleemitter-Laserdioden haben Erstreckungen von 1 µm in y-Richtung und 1,5 bis 5 µm in x-Richtung.
Dargestellt sind in der Fig. 1 insgesamt zwölf der Singleemitter-Laserdioden 2, die jeweils in drei Gruppen 8 zu je vier der Singleemitter-Laserdioden 2 angeordnet sind. Die vier Laserdioden 2 einer Gruppe 8 sind jeweils an einem gemeinsamen Trag- und Kühlkörper 9 parallel und äquidistant zueinander beabstandet angeordnet, wobei sie in positiver z-Richtung abstrahlen. Die Laserdioden 2 der in der Fig. 1 links dargestellten Gruppe 8 sind von unten nach oben mit 2a, 2b, 2c und 2d bezeichnet. Jeder der Laserdioden 2a bis 2d ist ein 90°-Umlenkspiegel 10a bis 10d zugeordnet. Ausgewählte dieser Umlenkspiegel 10 dienen zur Zusammenführung der Einzel-Ausgabestrahlen 3 zum Gesamt-Ausgabestrahl 4 und werden daher nachfolgend auch als Zusammenführ-Umlenkspiegel bezeichnet. Der Zusammenführung dienen dabei die Umlenkspiegel 10b bis 10d.

Die Umlenkspiegel 10 sind entsprechend den x-Positionen der Laserdioden 2a bis 2d nicht nur in x-Richtung zueinander versetzt angeordnet, sondern auch in z-Richtung zueinander versetzt angeordnet. Dies gewährleistet, dass an jedem der Zusammenführ-Umlenkspiegel 10b bis 10d ein erster, vom Zusammenführ-Umlenkspiegel 10b bis 10d nicht reflektierter Einzel-Ausgabestrahl 3 mit mindestens einem zweiten, vom Zusammenführ-Umlenkspiegel 10b bis 10d reflektierten Einzel-Ausgabestrahl 3 zusammengeführt wird. Diese Situation ist am Beispiel des Zusammenführ-Umlenkspiegels 10b in der Fig. 3 vergrößert dargestellt. Der vom Zusammenführ-Umlenkspiegel 10b nicht reflektierte Einzel-Ausgabestrahl 3 ist in der Fig. 3 mit 3a und der vom Zusammenführ-Umlenkspiegel 10b um 90° reflektierte Einzel-Ausgabestrahl 3 ist in Fig. 3 mit 3b bezeichnet.

Der Fig. 3 ist zu entnehmen, dass der Zusammenführ-Umlenkspiegel 10b derart angeordnet ist, dass weder der gesamte Bündelquerschnitt des vorbeigeführten, nicht reflektierten Einzel-Ausgabestrahls 3a noch der gesamte Bündelquerschnitt des reflektierten Einzel-Ausgabestrahls 3b zu einem zusammengeführten Zwischen-Ausgabestrahl 11 beitragend genutzt wird. Vielmehr wird am Zusammenführ-Umlenkspiegel 10 ein Teil des nicht reflektierten Einzel-Ausgabestrahls 3a und auch ein Teil des reflektierten Einzel-Ausgabestrahls 3b abgeschnitten, so dass die abgeschnittenen Querschnitts-Teile nicht zum Zwischen-Ausgabestrahl 11 beitragen. Eine Grenzlinie zwischen dem genutzten und dem abgeschnittenen, jeweils einfallenden Einzel-Ausgabestrahl 3a, 3b und dem abgeschnittenen Anteil dieser Einzel-Ausgabestrahlen 3a, 3b ist in der Fig. 3 bei 12 dargestellt.

Die Intensitätsverhältnisse zwischen den genutzten und den abgeschnittenen Anteilen der Einzel-Ausgabestrahlen 3a, 3b verdeutlicht Fig. 5. Das Intensitätsprofil der Einzel-Ausgabestrahlen 3 ist bei den Singleemitter-Laserdioden 2 in etwa gaußförmig. Jenseits der Grenzlinie 12 wird maximal 10% der gesamten Bündelintensität abgeschnitten. Dies bedeutet, dass nach dem Zusammenführ-Umlenkspiegel 10b jeweils 90% der Intensitäten der Einzel-Ausgabestrahlen 3a und 3b im Zwischen-Ausgabestrahl 11 genutzt werden. Die Einzel-Ausgabestrahlen 3a, 3b können auf diese Weise bei nur geringen Verlusten sehr eng, nämlich praktisch ohne Zwischenraum, nebeneinander geführt werden. Bei den Zusammenführ-Umlenkspiegeln 10c und 10d liegen in Bezug auf das teilweise Abschneiden der dort vorbeigeführten bzw. reflektierten Einzel-Ausgabestrahlen 3 die gleichen Verhältnisse vor, wie vorstehend unter Bezugnahme auf die Fig. 3 beim Zusammenführ-Umlenkspiegel 10b beschrieben. Im Strahlengang der Einzel-Ausgabestrahlen 3 liegt nach dem Zusammenführ-Umlenkspiegel 10d daher ein Zwischen-Ausgabestrahl 11 mit vier ohne Zwischenraum nebeneinanderliegend angeordneten Einzel-Ausgabestrahlen 3 vor, wobei jeweils 90% der ursprünglichen Strahlemission der Laserdioden 2 genutzt wird.

Dieser Vierfach-Ausgabestrahl wird anschließend von einem weiteren 90°-Umlenkspiegel 13 umgelenkt, so dass er nachfolgend in positiver z-Richtung propagiert. Im weiteren Verlauf wird dieser vierfache Zwischen-Ausgabestrahl 11 an einem weiteren Zusammenführ-Umlenkspiegel 14 vorbeigeführt. Dieses Vorbeiführen ist in einer schematischen Übersicht in der Fig. 2 und vergrößert in der Fig. 4 dargestellt. Am Zusammenführ-Umlenkspiegel 14 werden wiederum etwa 10% der Intensität des vorbeigeführten vierfachen Zwischen-Ausgabestrahls 11 abgeschnitten. Die entsprechende Grenzlinie 12 ist in der Fig. 4 eingezeichnet. Gleichzeitig wird vom Zusammenführ-Umlenkspiegel 14 ein weiterer vierfacher Zwischen-Ausgabestrahl 15 in der x-z-Ebene um 90° umgelenkt, so dass er anschließend ebenfalls in positiver z-Richtung propagiert. Wie der Darstellung der Fig. 4 entnommen werden kann, wird, analog wie bei den Zusammenführ-Umlenkspiegeln 10b bis 10d, nicht die gesamte Intensität des Zwischen-Ausgabestrahls 15 reflektiert, sondern lediglich 90% hiervon. Ein abgeschnittener Anteil des vierfachen Zwischen-Ausgabestrahls 15, der nicht reflektiert wird, ist in der Fig. 4 gestrichelt bei 16 dargestellt. Auch der Zusammenführ-Umlenkspiegel 14 sorgt dafür, dass im Strahlengang nach diesem Zusammenführ-Umlenkspiegel 14 die Zwischen-Ausgabestrahlen 11, 15 praktisch ohne Zwischenraum eng zueinander benachbart verlaufen, ohne hierbei mehr als 10% der einfallenden Strahlintensität zu verlieren. Auch von den Zwischen-Ausgabestrahlen 11 und 15 wird also jeweils 10% der einfallenden Intensität abgeschnitten, so dass hinsichtlich der genutzten und der abgeschnittenen Intensität ebenfalls die Verhältnisse gelten, die vorstehend im Zusammenhang mit der Fig. 5 erläutert wurden.

Nach dem Zusammenführ-Umlenkspiegel 14 liegt daher ein Zwischen-Ausgabestrahl 17 vor, der aus insgesamt acht Einzel-Ausgabestrahlen 3 in einem 4x2-Muster zusammengesetzt ist, wobei in x-Richtung vier Ausgabestrahlen 3 nebeneinander und in y-Richtung zwei Ausgabestrahlen 3 übereinander verlaufen.

Im weiteren Verlauf des Zwischen-Ausgabestrahls 17 passiert dieser einen weiteren Zusammenführ-Umlenkspiegel 18, dessen Funktion dem Zusammenführ-Umlenkspiegel 14 entspricht. Am Zusammenführ-Umlenkspiegel 18 wird durch 90°-Umlenkung ein weiterer vierfacher Zwischen-Ausgabestrahl 19 zum achtfachen Zwischen-Ausgabestrahl 17 dazugekoppelt, wobei wiederum 10% der Intensitäten der reflektierten Einzel-Ausgabestrahlen 3 und 10% der Intensitäten der vier direkt am Zusammenführ-Umlenkspiegel 8 vorbeigeführten Einzel-Ausgabestrahlen 3 des achtfachen Zwischen-Ausgabestrahls 17 abgeschnitten werden.

Nach dem Zusammenführ-Umlenkspiegel 18 liegt somit ein Zwischen-Ausgabestrahl 20 vor, der aus praktisch ohne Zwischenraum nebeneinander verlaufenden zwölf Einzel-Ausgabestrahlen 3 aufgebaut ist, wobei jeweils vier Einzel-Ausgabestrahlen 3 in x-Richtung nebeneinander und drei Einzel-Ausgabestrahlen 3 in y-Richtung übereinander angeordnet sind. Dieser zwölffache Zwischen-Ausgabestrahl 20, der auch als Gruppen-Strahl-Array bezeichnet wird, wird sodann von einem Gruppen-Kollimator zur Verringerung des Bündelquerschnitts auf einen nachfolgenden 1/e-Bündelquerschnitt verengt, der bei der dargestellten Ausführung bei 4 bis 5 mm liegt. Da der zwölffache, also 4x3, Zwischen-Ausgabestrahl 20 insgesamt einen angenähert quadratischen Bündelquerschnitt hat, stellt die 1/e-Bündelquerschnitts-Angabe den 1/e-Durchmesser längs der x- oder längs der y-Richtung dar.

Der Gruppen-Kollimator 21 ist nach Art eines Galilei-Teleskops mit einer Plankonvexlinse 21a und einer Plankonkavlinse 21b ausgeführt. Das verengte Gruppen-Strahl-Array 20 wird anschließend über einen Einkoppel-Polarisator 22 mit einem weiteren verengten Gruppen-Strahl-Array 23 vereinigt, welches in entsprechender Weise ebenfalls aus den Ausgaben von zwölf Singleemitter-Laserdioden 2 gebildet wurde. Der einzige Unterschied zwischen den Gruppen-Strahl-Arrays 20 und 23 ist, dass das Gruppen-Strahl-Array 20 linear in der x-Richtung und das Gruppen-Strahl-Array 23 linear in der y-Richtung polarisiert ist.

Nach dem Einkoppel-Polarisator 22 liegt der rote Gesamt-Ausgabestrahl 4 vor. Dieser wird im weiteren Verlauf über einen dichroitischen Einkoppelspiegel 24 mit einem Überlagerungsstrahl 25 aus einem grünen Gesamt-Ausgabestrahl 26 und einem blauen Gesamt-Ausgabestrahl 27 zusammengeführt. Der dichroitische Einkoppelspiegel 24 ist für rotes Licht maximal durchlässig und für grünes und blaues Licht maximal reflektierend. Der Überlagerungsstrahl 25 wird durch Überlagerung des grünen Gesamt-Ausgabestrahls 26 und des blauen Gesamt-Ausgabestrahls 27 an einem weiteren dichroitischen Einkoppelspiegel 28 erzeugt. Der dichroitische Einkoppelspiegel 28 ist für grünes Licht maximal durchlässig und für blaues Licht maximal reflektierend. Der grüne Gesamt-Ausgabestrahl 26 wird beispielsweise durch Frequenzverdoppelung eines Neodym-Festkörperlasers erzeugt. Auch der blaue Gesamt-Ausgabestrahl 27 kann durch einen Neodym-Festkörperlaser erzeugt werden, der resonatorintern frequenzverdoppelt wird. Die Wellenlänge des grünen Gesamt-Ausgabestrahls beträgt 532 nm. Die Wellenlänge des blauen Gesamt-Ausgabestrahls beträgt 473 nm.

Nach dem dichroitischen Einkoppelspiegel 24 liegt ein weißer Gesamt-Ausgabestrahl 29 vor, der einen Scanner 30 durchtritt. Dieser Scanner 30 lenkt den Gesamt-Ausgabestrahl 29 synchronisiert ab, so dass auf der Projektionsfläche 5, die vom Scanner 30 etwa 10 bis 20 m beabstandet ist, ein erwünschtes Lichtmuster entsteht. Der Betrieb des Scanners 30 ist bevorzugt mit nicht dargestellten Intensitätsmodulatoren synchronisiert, die in den Strahlengängen der Gesamt-Ausgabestrahlen 4, 26 und 27 angeordnet sind und die drei Grundfarben Rot, Grün und Blau unabhängig zur Bilderzeugung modulieren.

Wenn alle Einzel-Ausgabestrahlen 3 exakt parallel zueinander verlaufen, sieht der Querschnitt des Gesamt-Ausgabestrahls 4 nach dem Scanner 30 in etwa so aus, wie in der Fig. 7 dargestellt. Bedingt durch die etwas höhere Divergenz in der y-Richtung sind die Einzel-Ausgabestrahlen 3 in y-Richtung etwas stärker aufgeweitet als in x-Richtung, so dass die Strahldurchmesser Δy der Einzel-Ausgabestrahlen 3 größer sind als die Strahldurchmesser Δx in hierzu senkrechter x-Richtung. Dieser Effekt wird durch die Tatsache ausgeglichen, dass in y-Richtung im Gesamt-Ausgabestrahl 4 drei nebeneinanderliegende Einzel-Ausgabestrahlen 3 vorliegen, während in der x-Richtung vier nebeneinanderliegende Einzel-Ausgabestrahlen 3 vorliegen, so dass der Gesamt-Ausgabestrahl 4 nach dem Scanner 30 eine angenähert quadratische Einhüllende hat.

Fig. 8 zeigt den Gesamt-Ausgabestrahl 4 nach weiterer Propagation um etwa 10 bis 20 m kurz vor dem Auftreffen auf die Projektionsfläche 5. Die Darstellung nach Fig. 8 ist nicht maßstäblich zur Darstellung nach Fig. 7. Divergenzbedingt sind die Einzel-Ausgabestrahlen 3 nun stärker aufgeweitet, wobei sich benachbarte Einzel-Ausgabestrahlen 3 nun durchdringen.

Fig. 9 zeigt eine Situation, bei der der Gesamt-Ausgabestrahl 4 durch Justage der Einzel-Ausgabestrahlen 3 kurz vor der Projektionsfläche 5 noch weiter zusammengeführt wurde. Die Umlenkspiegel 10 und insbesondere 14 und 18 wurden dabei so justiert, dass die Einzel-Ausgabestrahlen 3 in der y-Richtung allesamt in etwa auf einer Höhe liegen. Aus den drei übereinanderliegenden Reihen von jeweils vierfachen Zwischen-Ausgabestrahlen ist dann eine vierfache Reihe von Einzel-Ausgabestrahlen 3 geworden, die sich aufgrund des langen Propagationsweges stark durchdringen. Energetische Hauptstrahlen 31 der Einzel-Ausgabestrahlen 3 sind innerhalb des Gesamt-Ausgabestrahls 4, also insbesondere innerhalb der Gruppen-Strahl-Arrays 20, 23, längs des Strahlenganges dieser Gruppen-Strahl-Arrays 20, 23 durch diese Justage zusammengeführt. Durch weitere Justage der Umlenkspiegel 10 ist es möglich, den vierfachen Zwischen-Ausgabestrahl nach Fig. 9 auch in x-Richtung noch weiter zusammenzufassen. Der Bündeldurchmesser des Gesamt-Ausgabestrahls ist auf diese Weise nochmals verringert, was die Qualität der erzeugten Projektion auf der Projektionsfläche 5, insbesondere deren Kontrast, verbessert.

## Patentansprüche

1. Laservorrichtung (1) mit einer Mehrzahl von Singleemitter-Laserdioden (2), deren Einzel-Ausgabestrahlen (3) zu einem Gesamt-Ausgabestrahl (4) überlagert werden,
- wobei jeder Singleemitter-Laserdiode (2) ein erster Kollimator (7) zur Bündelung jedes Einzel-Ausgabestrahls (3) zugeordnet ist,
- wobei die Einzel-Ausgabestrahlen (3) zumindest einer Gruppe (8) von Singleemitter-Laserdioden (2) mit Hilfe einer Mehrzahl von Zusammenführ-Umlenkspiegeln (10b bis 10d, 14, 18) zu mindestens einem Gruppen-Strahl-Array (20, 23) zusammengeführt werden, in dem die Einzel-Ausgabestrahlen (3) zumindest während eines ersten gemeinsamen Strahlweges eng benachbart nebeneinander verlaufen,
- wobei an jedem Zusammenführ-Umlenkspiegel (10b bis 10d, 14, 18) mindestens ein erster, vom Zusammenführ-Umlenkspiegel (10b bis 10d, 14, 18) nicht reflektierter Einzel-Ausgabestrahl (3a) mit mindestens einem zweiten, vom Zusammenführ-Umlenkspiegel (10b bis 10d, 14, 18) reflektierten Einzel-Ausgabestrahl (3b) zusammengeführt wird,
**dadurch gekennzeichnet, dass** zumindest an einzelnen Zusammenführ-Umlenkspiegeln (10b bis10d, 14, 18) ein Teil des nicht reflektierten (3a) und/oder ein Teil des reflektierten (3b) Einzel-Ausgabestrahls (3) abgeschnitten wird, so dass die abgeschnittenen Querschnitts-Teile nicht zum Gruppen-Strahl-Array (20, 23) beitragen.

2. Laservorrichtung nach Anspruch 1, **dadurch gekennzeichnet, dass** der abgeschnittene Teil (16) mindestens 5% der Gesamtintensität des Einzel-Ausgabestrahls (3) vor dem Zusammenführ-Umlenkspiegel (10b bis 10d, 14, 18) beinhaltet.

3. Laservorrichtung nach Anspruch 1 oder 2, **dadurch gekennzeichnet, dass** an allen Zusammenführ-Umlenkspiegeln (10b bis 10d, 14, 18) ein Teil zumindest eines der Einzel-Ausgabestrahlen (3) abgeschnitten wird und nicht zum Gruppen-Strahl-Array (20, 23) beiträgt.

4. Laservorrichtung nach einem der Ansprüche 1 bis 3, **gekennzeichnet durch** einen Gesamt-Kollimator (21) zur Verringerung eines Bündelquerschnitts des mindestens einen erzeugten Gruppen-Strahl-Arrays (20, 23), insbesondere auf einen typischen 1/e-Bündelquerschnitt, der höchstens 10 mm beträgt.

5. Laservorrichtung nach einem der Ansprüche 1 bis 4, **dadurch gekennzeichnet, dass** die Zusammenführ-Umlenkspiegel (10b bis 10d, 14, 18) und gegebenenfalls weitere Umlenkspiegel (10a, 13) so justiert sind, dass die energetischen Hauptstrahlen der Einzel-Ausgabestrahlen (3) innerhalb des Gruppen-Strahl-Arrays (20, 23) längs des Strahlenganges des Gruppen-Strahl-Arrays (20, 23) zusammenrücken.

6. Laservorrichtung nach Anspruch 5, **dadurch gekennzeichnet, dass** die energetischen Hauptstrahlen der Einzel-Ausgabestrahlen (3) nach einem Lichtweg des Gruppen-Strahl-Arrays (20, 23) von mehr als 1 m zusammenfallen.

7. Laservorrichtung nach einem der Ansprüche 1 bis 6, **gekennzeichnet durch** den Einsatz von Singleemitter-Laserdioden (2) mit einem Aspektverhältnis (y/x) einer Emissionsfläche (6), der zwischen 1:1 und 1:5 liegt.

8. Laservorrichtung nach Anspruch 7, **dadurch gekennzeichnet, dass** eine lange Hauptachse (x) der Emissionsfläche (6) nicht länger ist als 2 µm.

9. Laservorrichtung nach Anspruch 7 oder 8, **gekennzeichnet durch** den Einsatz von Singleemitter-Laserdioden (2) mit einem Aspektverhältnis einer Divergenz (x/y) des Einzel-Ausgabestrahls (3), der zwischen 1:1 und 1:2 liegt.

10. Laservorrichtung nach einem der Ansprüche 7 bis 9, **dadurch gekennzeichnet, dass** die maximale Strahldivergenz der Singleemitter-Laserdioden (2) nicht größer ist als 30 mrad.

## Claims

1. Laser device (1) comprising a plurality of single-emitter laser diodes (2), the individual output beams (3) of which are superimposed to form a total output beam (4),
- wherein to each single-emitter laser diode (2) a first collimator (7) is assigned for bundling each individual output beam (3),
- wherein the individual output beams (3) of at least one group (8) of single-emitter laser diodes (2) are converged together by means of a plurality of converging deflecting mirrors (10b to 10d, 14, 18) into at least one group-beam-array (20, 23), in which the individual output beams (3) run closely adjacent to one another at least during a first common beam path,
- wherein at each converging deflection mirror (10b to 10d, 14, 18) at least one first individual output beam (3a) not reflected by the converging deflecting mirror (10b to 10d, 14, 18) is converged with at least one second individual output beam (3b) reflected by the converging deflection mirror (10b to 10d, 14, 18),
**characterised in that** at least at individual converging deflecting mirrors (10b to 10d, 14, 18) a portion of the non-reflected (3a) individual output beam and/or a portion of the reflected (3b) individual output beam (3) is cut off, so that the cut-off cross sectional parts do not contribute to the group beam array (20, 23).

2. Laser device according to claim 1, **characterised in that** the cut-off portion (16) contains at least 5% of the total intensity of the individual output beam (3) in front of the converging deflecting mirror (10b to 10d, 14, 18).

3. Laser device according to claim 1 or 2, **characterised in that** on all converging deflecting mirrors (10b to 10d, 14, 18) a portion of at least one of the individual output beams (3) is cut off and does not contribute to the group beam array (20, 23).

4. Laser device according to one of claims 1 to 3, **characterised by** an overall collimator (21) for reducing a bundle cross section of the at least one generated group beam array (20, 23), in particular to a typical 1/e bundle cross section, which is at most 10 mm.

5. Laser device according to one of claims 1 to 4, **characterised in that** the converging deflecting mirrors (10b to 10d, 14, 18) and possibly additional deflecting mirrors (10a, 13) are aligned so that the energetic main beams of the individual output beams (3) inside the group beam array (20, 23) move together along the beam path of the group beam array (20, 23).

6. Laser device according to claim 5, **characterised in that** the energetic main beams of the individual output beams (3) coincide after a light path of the group beam array (20, 23) of more than 1 m.

7. Laser device according to one of claims 1 to 6, **characterised by** the use of single-emitter laser diodes (2) with an aspect ratio (y/x) of an emission area (6) which is between 1:1 and 1:5.

8. Laser device according to claim 7, **characterised in that** a long main axis (x) of the emission area (6) is not longer than 2 µm.

9. Laser device according to claim 7 or 8, **characterised by** the use of single-emitter laser diodes (2) with an aspect ratio of a divergence (x/y) of the individual output beam (3) which is between 1:1 and 1:2.

10. Laser device according to one of claims 7 to 9, **characterised in that** the maximum beam divergence of the single-emitter laser diodes (2) is not greater than 30 mrad.

## Revendications

1. Dispositif laser (1) avec une multitude de diodes lasers mono-émetteurs (2) dont les faisceaux de sortie individuels (3) sont superposés en un faisceau de sortie global (4),
- un premier collimateur (7) étant agencé à chaque diode laser mono-émetteur (2) pour la focalisation de chaque faisceau de sortie individuel (3),
- les faisceaux de sortie individuels (3) d'au moins un groupe (8) de diodes lasers mono-émetteurs (2) étant réunis à l'aide d'une multitude de miroirs de renvoi de réunion (10b à 10d, 14, 18) en au moins un réseau de groupes de faisceaux (20, 23) dans lequel les faisceaux de sortie individuels (3) sont très proches les uns des autres sur au moins une première trajectoire de faisceaux commune,
- où, à chaque miroir de renvoi de réunion (10b à 10d, 14, 18), au moins un premier faisceau de sortie individuel (3a), non réfléchi par le miroir de renvoi de réunion (10b à 10d, 14, 18) est uni à au moins un deuxième faisceau de sortie individuel (3b) réfléchi par le miroir de renvoi de réunion (10b à 10d, 14, 18), **caractérisé en ce qu'**au moins une partie du faisceau de sortie individuel (3) non réfléchi (3a) et/ou réfléchi (3b) est coupée au niveau de certains miroirs de renvoi de réunion (10b à 10d, 14, 18) de sorte que les parties de section transversale coupées ne contribuent pas au réseau de groupe de faisceaux (20, 23).

2. Dispositif laser selon la revendication 1 **caractérisé en ce que** la partie coupée (16) comprend à au moins 5 % de l'intensité globale du faisceau de sortie individuel (3) avant le miroir de renvoi de réunion (10b à 10d, 14, 18).

3. Dispositif laser selon les revendications 1 ou 2 **caractérisé en ce que** sur tous les miroirs de renvoi de réunion (10b à 10d, 14, 18) une partie au moins d'un faisceau de sortie individuel (3) est coupée et ne contribue pas au réseau de groupes de faisceau (20, 23).

4. Dispositif laser selon l'une des revendications de 1 à 3 **caractérisé par** un collimateur global (21) pour le rétrécissement de la section transversale de faisceau d'au moins un des réseaux de groupes de faisceaux (20, 23) générés, en particulier d'une section transversale de faisceau 1/e typique qui est au plus de 10 mm.

5. Dispositif laser selon l'une des revendications de 1 à 4 **caractérisé en ce que** les miroirs de renvoi de réunion (10b à 10d, 14, 18) et éventuellement d'autres miroirs de renvoi (10a, 13) sont ajustés de sorte que les raies principales énergétiques des faisceaux de sortie individuels (3) se rassemblent à l'intérieur des réseaux de groupes de faisceaux (20, 23) le long du chemin optique des réseaux de groupes de faisceaux (20,23).

6. Dispositif laser selon la revendication 5 **caractérisé en ce que** les raies principales énergétiques des faisceaux de sortie individuels (3) coïncident après un trajet optique du réseau de groupes de faisceau (20, 23) de plus d'1 m.

7. Dispositif laser selon l'une des revendications de 1 à 6 **caractérisé par** l'introduction de diodes lasers mono-émetteurs (2) avec un rapport d'aspect (y/x) d'une surface d'émission (6) qui se situe entre 1 : 1 et 1 : 5.

8. Dispositif laser selon la revendication 7 **caractérisé en ce qu'**un axe principal long (x) de la surface d'émission (6) n'est pas plus long que 2 µm.

9. Dispositif laser selon les revendications 7 ou 8 **caractérisé par** l'introduction de diodes lasers mono-émetteurs (2) avec un rapport d'aspect d'une divergence (x/y) du faisceau de sortie individuel (3) qui se situe entre 1 : 1 et 1 : 2.

10. Dispositif laser selon l'une des revendications de 7 à 9 **caractérisé en ce que** la divergence de faisceau maximale des diodes lasers mono-émetteurs (2) n'est pas plus élevée que 30 mrad.
